# EUROPEAN PATENT SPECIFICATION

(11) **EP 0 375 426 B1**
(45) Date of publication and mention of the grant of the patent: **20.03.1996**
(21) Application number: 89313446.0
(22) Date of filing: 21.12.1989
(51) Int. Cl.: H01S 3/19, H01S 3/085, H01S 3/103, H01L 33/00

(54) **Semiconductor optical device**
Optische Halbleitervorrichtung
Dispositif optique à semi-conducteur

(30) Priority: 21.12.1988 JP 324671/88; 23.05.1989 JP 129343/89
(43) Date of publication of application: 27.06.1990
(73) Proprietor: OPTICAL MEASUREMENT TECHNOLOGY CO., LTD., Musashinl-shi Tokyo 180 (JP)
(72) Inventor: Hirata, Takaaki, Tyuou-ku Tokyo 104 (JP)
(74) Representative: Blanco White, Henry Nicholas

(56) References cited:
- JP-A-63 255 986
- US-A- 4 755 015
- ELECTRONICS LETTERS, vol. 20, no. 9, April 1984, pages 383-384, London, GB; Y. SUZUKI et al.: "Fabrication of GaAlAs 'Window-stripe' multi-quantum-well heterostructure lasers utilising Zn diffusion-induced alloying"
- SEMICONDUCTOR SCIENCE, & TECHNOLOGY, vol. 2, no. 12, December 1987, pages 793-796, Bristol, GB; M. RAZEGHI et al.: "Disorder of a GaxIn1-xAsyP1-y-InP quantum well by Zn diffusion"
- JAPANESE JOURNAL OF APPLIED PHYSICS/PART 2, vol. 24, no. 8, August 1985, pages L647-L649, Tokyo, JP; H. NAKASHIMA et al.: "AlGaAs window stripe buried multiquantum well lasers"
- PATENT ABSTRACTS OF JAPAN, vol. 10, no. 168 (E-411), 14th June 1986;& JP-A-61- 018 192
- JAPANESE JOURNAL OF APPLIED PHYSICS/PART 2, vol. 25, no. 8, August 1986, pages L690-L697, Tokyo, JP; K. ISHIDA et al.: "Fabrication of index-guided AlGaAs multiquantum well lasers with buried optical guide by Si-induced disordering"
- IEEE JOURNAL OF QUANTUM ELECTRONICS, Vol. QE-11, No. 7, July 1975, pages 432-435

## Description

This invention relates to a semiconductor optical device using a quantum well structure, and more particularly to a semiconductor structure surrounding a quantum well structure.

When various optical devices are to be formed on a common substrate to operate with the same frequency band, it is necessary to use semiconductors of different optical characteristics, especially of different band gaps depending on the type of the optical device. Semiconductors of different band gaps are conventionally coupled optically on the same substrate by partially etching a semiconductor thin film which has been epitaxially grown, and by growing another semiconductor of a different band gap thereon. This method has been disclosed, for instance, in S. Murata, I. Mito and K. Kobayashi's paper entitled "Spectral characteristics for a 1.5 µm DBR laser with frequency-tuning region", IEEE Journal of Quantum Electronics, Vol.QE-23, No. 6, June, 1987.

The prior art method is cumbersome as the steps of etching and crystal growing are repeated since the method separately grows semiconductors of different band gaps. Further, it is difficult to grow each of the semiconductor layers flatly. It is also difficult to enhance coupling coefficient between the devices because the structures of waveguides differ from each other.

When the optical device is a semiconductor laser, it is necessary to reduce optical absorption at the laser facets in order to enhance reliability and increase output power. If optical absorption occurs at the facets, COD (catastrophic optical damage) such as melting of the facets with excessive local heat tends to take place. In order to eliminate optical absorption at the facets, the band gap at the facet should be larger than the band gap at the active region. For this purpose, there have been known the following method; (1) the facet is etched and buried with a substance having a large band gap, or (2) the change (an increase) of a band gap caused by the disordering of a quantum well structure is used.

The method (1) is described in detail in, for instance, "Large optical cavity AlGaAs buried hetero-structure window lasers" by S. Margalit and A. Yariv; Appl. Phys. Lett. 40 (12), June 15, 1982. The method (2) is described in detail in "High power (2.1 W) 10-stripe AlGaAs laser arrays with Si disordered facet windows" by R. L. Thornton, D. F. Welch, R. D. Burnham, T. L. Paoli and P. S. Cross; Appl. Phys. Lett. 49 (23), December 8, 1982.

However, the method (1) above is not quite satisfactory in that, the manufacturing process becomes complicated as it is necessary to bury the facet portion of a semiconductor laser. The method (2) is also defective in that as the Si is diffused thermally by contacting Si on the facet, the process should be conducted separately from other semiconductor optical devices, which inevitably makes the manufacturing process complicated. Further, the places where a semiconductor laser can be formed are limited on an optical IC.

JP-A-63 255986 discloses a semiconductor laser element including a multiple quantum well layer structure. Part of the quantum well structure is disordered by doping, and constitutes an optical waveguide region: the undoped region constitutes an active region bounded by the disordered region.

Japanese Journal of Applied Physics, Part 2, Vol. 25 No. 8 [August 1986], pages L690 to L697 discloses a semiconductor laser element in which separate superimposed, multiple quantum well active and waveguide layers are formed, and parts of the waveguide layer are disordered by ion implantation to define a waveguide region. Care is taken that the implantation does not affect the more deeply buried active region.

IEEE Journal of Quantum Electronics, Vol. QE-11, No. 7 [July 1975], pages 432 to 435, describes an optical waveguide in the form of a rib raised from a slab. Slab-guided modes are allowed to dissipate through the edges of the slab, and the few modes that can propagate in the rib but not in the slab are thus selectively guided along the rib.

The invention provides a process for manufacturing a semiconductor optical device, comprising a first epitaxial step of forming on a substrate a quantum well structure including an active layer and a guiding layer on said quantum well structure, a step of etching said guiding layer to form a rib waveguide, a step of disordering part of said quantum well structure, said etching and disordering steps not necessarily carried out in that order, the degree of the disordering being controlled to set the band gap of the corresponding part of the active layer variably, thus forming a waveguiding region which includes said rib waveguide and a disordered part of said quantum well structure, the non-disordered part of said quantum well structure being used as an active region whose output light is guided in said waveguiding region, and a second epitaxial step of embedding the rib waveguide in a cladding layer.

The invention also provides a semiconductor optical device comprising a substrate a quantum well structure including an active layer and a rib waveguide on said quantum well structure, said quantum well structure having a disordered part such that the band gap of the corresponding part of the active layer is set variably, a waveguiding region which includes said rib waveguide and a disordered part of said quantum well structure, the non-disordered part of said quantum well structure being used as an active region whose output light is guided in said waveguiding region, said rib waveguide being embedded in a cladding layer.

Disordering may be achieved by ion implantation and thermal processing, and the degree of disordering may be controlled by controlling at least either the dose level or implanation energy. The degree of disordering may also be controlled by properly selecting an implanation ion species.

Because ions are implanted between the two epitaxy steps, as the distance between the ion-implanted surface and the quantum well structure is small at the time of ion implantation, the dose level and implantation energy can be reduced. This can in turn decrease the absorption on the region where ions are implanted.

It is preferable to conduct the thermal processing with the temperature raised in the second epitaxy step.

In the region where the quantum well structure has been disordered by the aforementioned method, a Bragg reflector region, a frequency tunable Bragg reflector region where reflected frequency is tunable, a resonant optical reflector (hereinafter referred to as ROR) and a frequency tunable ROR region where reflected frequency is tunable may be formed. Facets of a quantum well structure may be disordered by the method similar to the above.

Once the quantum well structure is disordered and the disordering degree progresses, the effective well width is reduced to change the first quantum energy level as well as to increase the band gap. When the structure is fully disordered, the band gap increases up to the value of the barrier layer. Then, the region which has not disordered at all may be used as an active region while the regions which are at least partially disordered may be used as optical waveguides, a DBR region, an ROR region, a phase control region, a PM modulation region, an AM modulation region, etc.

When a facet portion of a quantum well structure is disordered, band gap increases to form a non-absorbing facet. The method according to this invention conducts the step of disordering by ion implantation and thermal processing. By using ion implantation, the region which is to be disordered can be precisely determined so that a non-absorbing facet is formed on a semiconductor laser at an arbitrary position on the substrate.

The semiconductor optical device according to this invention is effective in that optical devices having various and different band gaps may be formed on a substrate without complicated steps in crystal growth because the band gaps can be controlled by the degree of disordering of the quantum well structure. Moreover, it is effective in that the coupling coefficient can be increased as the waveguide structures are the same as in all the regions.

The method may be used for the case where a non-absorbing facet is formed similarly to the manufacturing process of other optical ICs.

### [Brief Description of the Drawings]

FIGs. 1a - 1h are views to show the manufacturing process of a semiconductor optical device where a frequency tunable Bragg reflector laser, an AM modulator and a PM modulator are integrated on a substrate.
FIG. 2 is a cross sectional view of the device shown in Fig. 1;
FIG. 3 is a cross sectional view of the device shown in Fig. 1;
FIGs. 4a - 4d are graphs to show the changes in energy band caused by disordering;
FIG. 5 is a graph to show Al mole fraction of a quantum well structure;
FIG. 6a - 6f are views to show the manufacturing process of one embodiment of the semiconductor optical device according to this invention where a facet portion of a semiconductor laser is disordered;
FIG. 7 is a graph to show an example of output power against the injected current of a comparison device;
FIG. 8 is a graph to show an example of output power against injected current of the device shown in Fig. 6;
FIG. 9 is a graph to show another example of output power against injected current of the device shown in Fig. 6;
FIGs. 10a - 10f are views to show the manufacturing process of another embodiment of semiconductor optical device according to this invention where a DBR laser is manufactured;
FIGs. 11a - 11f are views to show the manufacturing process of a further embodiment of semiconductor optical device where according to this invention where a frequency tunable DBR laser is manufactured;
FIG. 12a - 12f are views to show the manufacturing process of a further embodiment of semiconductor optical device according to this invention where an ROR laser is manufactured; and
FIG. 13a - 13f are views to show the manufacturing process of a further embodiment of semiconductor optical device according to this invention where a frequency tunable ROR laser is manufactured.

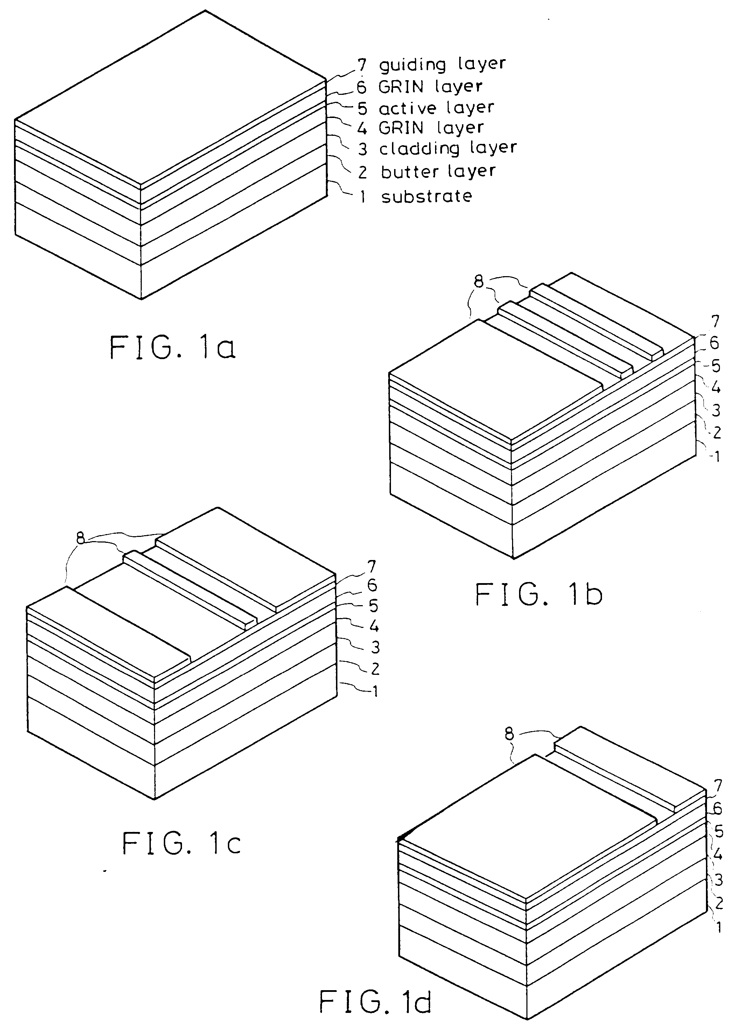

FIGs. 1a - 1h show the manufacturing process of a semiconductor optical device. In the figures, a GRIN-SCH-SQW (graded index - separate confinement heterostructure - single quantum well) structure is used as the quantum well structure, and a substrate is integrated with a frequency tunable DBR laser, an AM modulator and a PM modulator. In this case, disordering is controlled with the dose level in Si ion implantation and the growing process is divided into the first and second epitaxy steps. Ion implantation is conducted after the first epitaxy step, and the temperature increased in the second epitaxy step is used for the thermal processing subsequently to the ion implantation.

As shown in FIG. 1a, on a substrate 1 is grown a buffer layer 2, a cladding layer 3, a GRIN layer 4, an active layer, another GRIN layer 6, and a guiding layer 7 sequentially. The GRIN layer 4, the active layer 5 and the GRIN layer 6 construct a quantum well structure.

The quantum well structure is disordered by ion implantation and thermal processing. At the time of ion implantation, a mask 8 having a window open on the region where the optical device is to be formed is set on the guiding layer 7 to control the dose level according to the band gap required for the optical device. FIGs. 1b through 1d show the mask shapes for forming a waveguide region for connecting individual optical devices, a refractive index control region for variably controlling refractive index against radiated light and an absorption coefficient control region for variably controlling absorption coefficient against radiated light. Si is used as the implantation ion, and the dose levels for each region are denoted respectively as S₁ , S₂ and S₃, provided the relation below holds.
S₁ > S₂ > S₃

The quantum well structure disordered by thermal processing after the ion implantation. The degree of disordering varies depending on the dose level of the particular region. The disordering of a quantum well structure by the ion implantation and thermal processing is described in: Masashi Uematsu & Fumihiko Yamagawa, "Compositional disordering of Si-implanted GaAs/AlGaAs superlattices by rapid thermal annealing", JPN. J. Appl. Phys. Vol.26, No. 8, August 1987, pp.L1407-L1409.

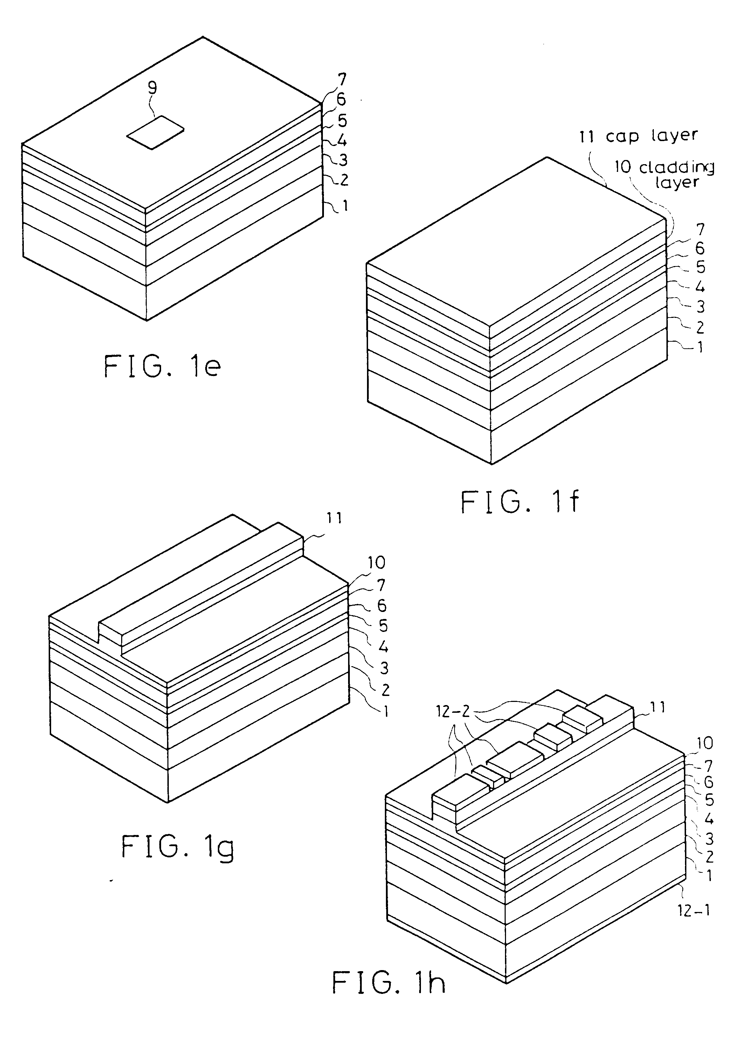

FIGs. 1e through 1h show the steps after completion of the ion implantation.

In the steps after the ion implantation, a grating is formed on the surface of the guiding layer 7 corresponding to the position where a DBR region is to be formed as shown in FIG. 1e. Then, as shown in FIG. 1f, a cladding layer 10 and a cap layer 11 are grown, and etched in a mesa structure as shown in FIG. 1g. Electrodes 12-1, 12-2 are then formed as shown in FIG. 1h. As the temperature rises while the cladding layer 10 and the cap layer 11 are grown, the heat is used for the thermal processing subsequent to the ion implantation.

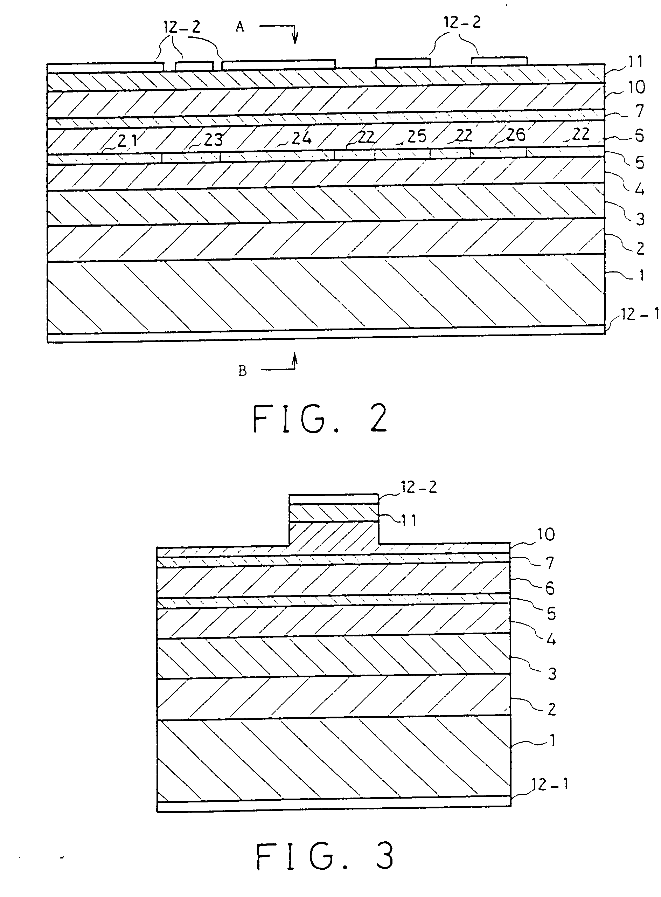

FIG. 2 shows a cross section of the semiconductor optical device in the longitudinal direction of the mesa structure while FIG. 3 shows the cross section of the line A-B in FIG. 2.

The semiconductor optical device is obtained by using the quantum well structure which has not been disordered as an active region 21, forming a waveguide 22 on the waveguide region, a phase control region 23, a DBR region 24 and a PM modulation region 25 on the refractive index control region, and an AM modulation region 26 on the absorption control region.

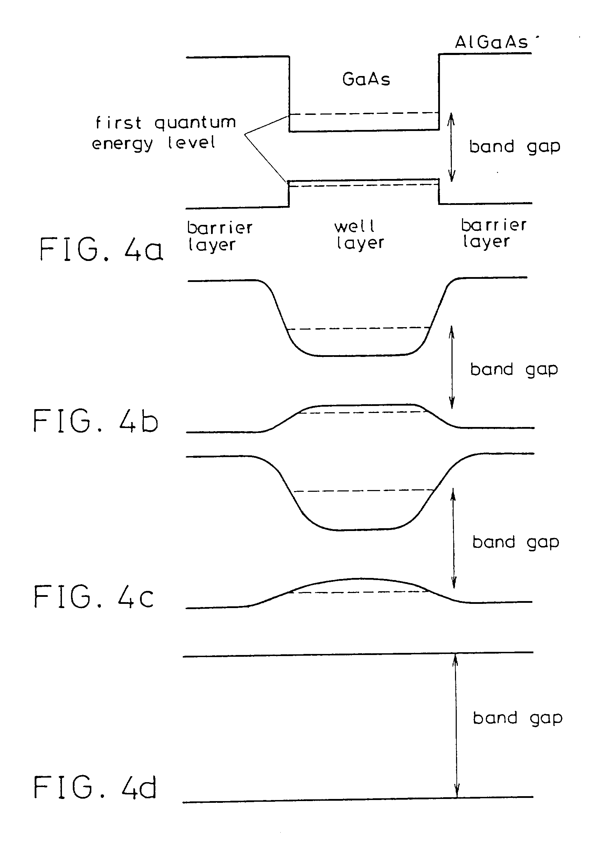

FIGs. 4a - 4d show the changes in the energy band caused by disordering. FIG. 4a shows the state prior to disordering, FIGs. 4b and 4c show the states where disordering has progressed, and FIG. 4d shows the state where the disordering is completed. As the disordering progresses, the effective width of the well decreases, the first quantum energy level changes, and the band gap increases.

The region which is not disordered maintain the band gap of epitaxial growth. This region is used as the active region 21. The frequency oscillated by the region 21 is determined by the band gap thereof.

The band gap is expanded by disordering in the absorption control region, and the absorption edge is slightly shifted toward the side of the short wavelength. This in turn shifts the absorption edge corresponding to the band gap toward the short wave from the oscillation wavelength of the region 21. Under the normal state, it becomes transparent. But if electric current or voltage is applied on the region, the edge is shifted toward the long wave side, and the region may be used as an AM modulation region 26 using the changes in absorption coefficient.

As the dose level of the refractive index control region is larger than that of the absorption region, that region is objected to large degree of disordering. The band gap thereof is far greater than that of the absorption coefficient control region, and thus is less susceptible to changes in a absorption coefficient by electric current or voltage. When electric current or voltage is applied, however, the refractive index is changed due to the effect of plasma, Stark shift, etc. Utilizing such changes in the refractive index, the region may be used as the phase control region 23, the DBR region 24, and the PM modulation region 25.

Disordering progresses in the waveguide region further to increase the band gap. The absorption edge shifts toward the side of shorter wave, and the waveguide loss becomes smaller. The region may, therefore, be used as the waveguide 22.

The active region 21, the phase control region 23 the DBR region 24 and the structure neighboring them form a frequency tunable DBR laser, the AM modulation region 26 and the structure neighboring it form an AM modulator, and the PM modulation region 25 and the structure neighboring it form a PM modulator. The operation of the frequency tunable DBR laser is described in detail in S. Murata, I. Mito and K. Kobayashi, "Over 720 GHz (5.8 nm) frequency tuning by a 1.5 um DBR laser with phase and Bragg wavelength control regions" Electronics Lett., Vol.23, No.8, April 9, 1987.

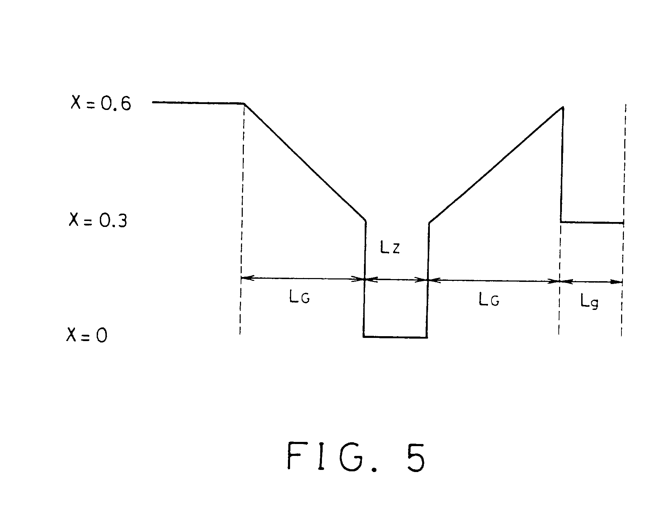

FIG. 5 shows the Al mole fraction of the quantum well structure of the semiconductor optical device which was actually manufactured.

In this device, GaAs was used as the active layer 5 while Al Ga As was used as the GRIN layers 4, 6 and the guiding layer 7. The width Lz of the active layer 5 (quantum well width) was 7.5 nm, the width L of the GRIN layers 4, 6 was 150 nm and the width Lg of the guide layer 7 was 50 nm. Using Si as the implantation ion, the quantum well structure was implanted with ions under the following conditions:
(1) Waveguide region:
   - implantation energy: 100 KeV,
   - dose levels: S₁ = 1 x 10¹ - 1 x 10¹⁵ cm⁻
(2) Refractive index control region, absorption coefficient control region:
   - implantation energy: 100 KeV
   - dose levels: S₂, S₃ = 1 x 10¹¹ - 1 x 10¹³ cm⁻.

The region was processed as shown in FIGs. 1e through 1h to form the semiconductor optical devices shown in FIGs. 2 and 3, and their operations were confirmed. The temperature the second epitaxy step (FIG. 1f) was 770° C in 40 minutes.

The table below shows the result of measurement of waveguide losses against Si dose levels.

| Si dose level | waveguide loss (cm⁻¹ ) |
|---|---|
| 1.5 x 10¹³ cm⁻ | 5.0 |
| 1.0 x 10¹³ cm⁻ | 4.4 |
| 0.7 x 10¹³ cm⁻ | 12.0 |

The values in the table were obtained when measurement was taken under the following conditions:
Substrate 1 : GaAs
Buffer layer 2 : n-type GaAs
Cladding layer 3 : n-type Al_{0.6} Ga_{0.4} As
GRIN layer 4 : undoped AlₓGa₁₋ₓ As
The layer obtained by disordering the undoped quantum well layer.
GRIN layer 6 : undoped AlₓGa₁₋ₓ As
Guiding layer 7 : undoped Al_{0.3} Ga_{0.7} As
Cladding layer 10 : p-type Al₀.₆ Ga_{0.4} As
Wave guide width : 6 µm
Frequency used in measuring : 845 nm

The above embodiment shows a case where the degree of disordering was controlled by the dose level of ion implantation, but it may be controlled by the implanted ion species. For instance, P. Mei, T. Ven-katesan, S. A. Schwarz, N. G. Stoffel, J. P. Harbison, D. L. Hart and L. A. Florez taught, in their paper titled "Comparative studies of ion-induced mixing of GaAs-AlAs superlattices", Appl. Phys. Lett. 52 (18), May 2, 1988, pp.1487-1479, that the degree of disordering was controlled by selecting the species of implantation ions similar thermal process was carried out.

The quantum well structure shown in FIG. 5 of the quantum well width Lz = 7.5 nm, the width of the GRIN layer 4, 6 L_{G} = 100 nm, the width of the guide layer 7 Lg = 50 nm were implanted under the following conditions:

### (1) Waveguide region

| | |
|---|---|
| Species of implanted Ions : | Si |
| Implantation energy : | 75 KeV |
| Dose level S₁ : | 1 x 10¹ - 1 x 10¹⁴ cm⁻ |

### (2) Refractive index control region, absorption coefficient region:

| | |
|---|---|
| Species of implanted ions : | As |
| Implantation energy : | 400 KeV |
| Dose level S₂ S₃ | 1 x 10¹ - 1 x 10¹⁴ cm⁻ |

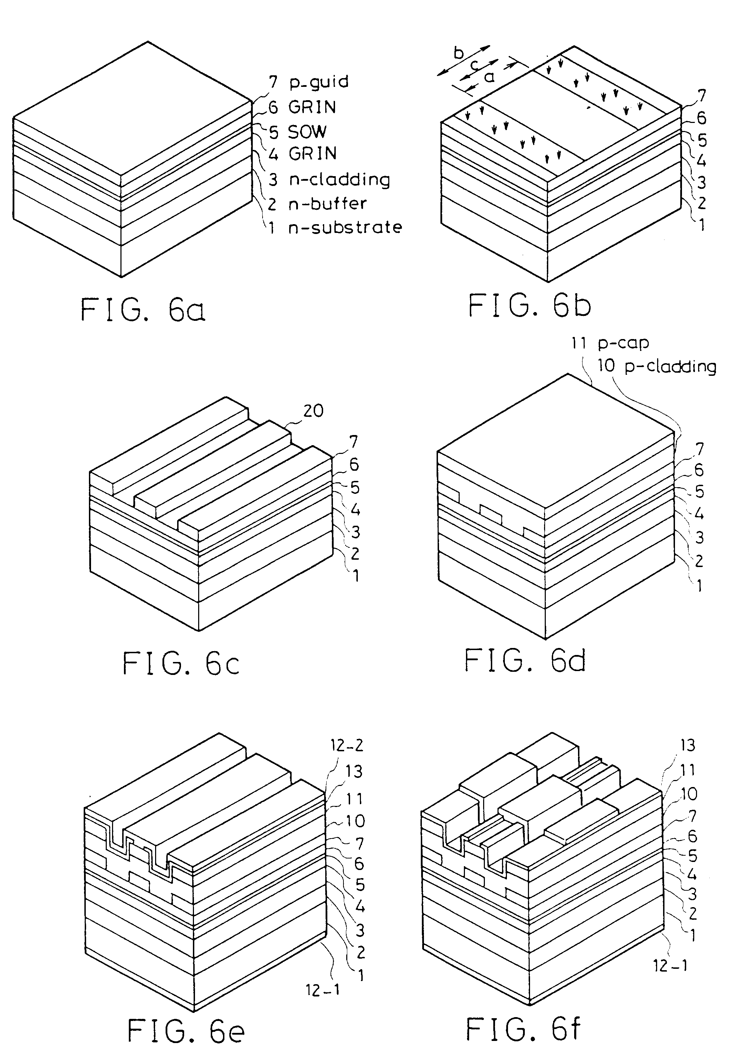

FIGS. 6a - 6f show the manufacturing process of an embodiment of a semiconductor optical device including a rib waveguide according to this invention. A sample product using GRIN-SCH-SQW structure as the quantum well structure will be described below.

As shown in FIG. 6a, an n-type buffer layer 2, an n-type cladding layer 3, a GRIN layer 4, a SQW active layer 5, a GRIN layer 6 and a guide layer 7 where formed epitaxially in this order on an n-type GaAs substrate 1. The composition of the layers from the n-type cladding layer 3 to the guide layer 7 was AlₓGa₁₋ₓAs, and the mole fraction x and the thickness thereof are as follows:

| | | |
|---|---|---|
| Cladding layer 3 | : x = 0.6, | 1.5 µm |
| GRIN layer 4 | : x = 0.6 - 0.3, | 0.15 µm |
| SQW active layer 5 | : x = 0, | 8 nm |
| GRIN layer 6 | : x = 0.3 - 0.6, | 0.15 µm |
| Guiding layer 7 | : x = 0.3, | 0.05 µm |

Then, as shown in FIG. 6b, ions were implanted on the two regions which were to be facets. The distance a between the two regions was 1000 µm. Si ions were used, the implantation energy was 100 KeV, and the dose level was 1 x 10¹³ cm⁻.

The guide layer 7 was etched as shown in FIG. 6c to form a rib waveguide 20. Then, a p-type cladding layer 10 and a p-type cap layer 11 were grown as shown in FIG. 6d. Their mole fractions x and thickness were respectively as follows:

| | | |
|---|---|---|
| Cladding layer 10 | : x = 0.6, | 1.5 µm |
| Cap layer 11 | : x = 0, | 0.3 µm |

The high temperature during the growth of the cladding layer 10 and the cap layer 11 was used for thermal processing after implantation.

As shown in FIG. 6e, the cap layer 10 and the cladding layer 11 were partially etched to form a ridge structure for current confinement, and an upper electrode 12-2 was formed after SiO₂ insulating layer 13 had been deposited. A lower electrode 12-1 was formed on the reverse surface of the substrate 1.

Lastly, as shown in FIG. 6f, the upper electrode 12-2 was removed correspondingly to the region which was to be a facet as shown in FIG. 6b, and cleaved to form disordered regions having the width of 50 µm on both sides of the semiconductor laser. The distance b between the cleaved facets was 1100 µm.

A device shown in FIG. 6f was cleaved inside the disordered two regions for comparison. The distance c between cleaved facets was 900 µm.

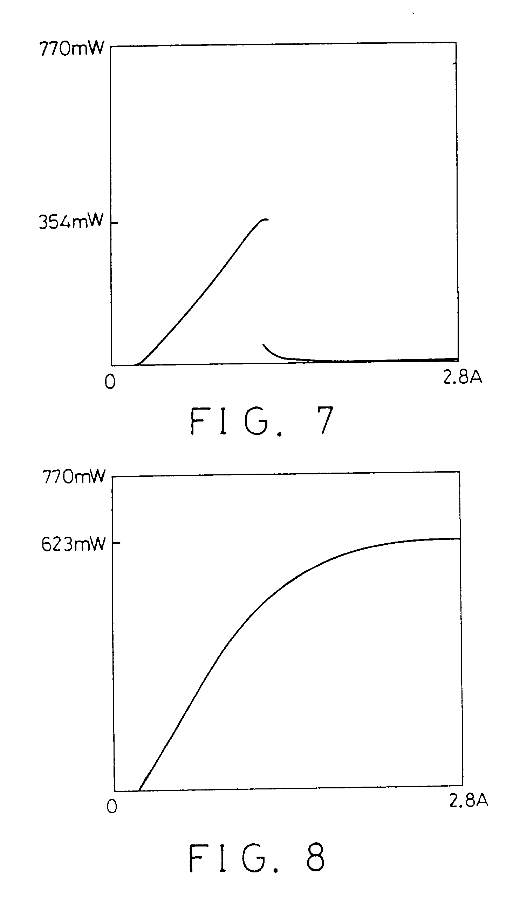

FIGs. 7 through 9 show the result of measurement of characteristics of the thus obtained embodiment and the comparison.

The graphs in FIGs. 7 and 8 show the relation of the output power and the injected current measured in the comparison and the embodiment.

Pulsed light was generated from this embodiment and the comparison devices at 20°C, in the time width of 400 ns and at the duty ratio of 0.1%. As a result, COD was caused when the output reached 354 mW in the comparison device. But in this embodiment, the output was saturated with the heat generated at 623 mW causing no COD.

As stated above, the cavity length was 1100 µm in this embodiment, and was 900 µm in the comparison device. The effect of disordering was quite obvious even though the cavity length differed.

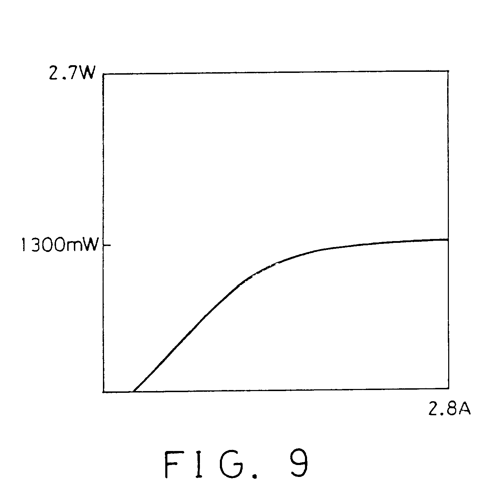

FIG. 9 shows an example of measurement of output power in relation to injected current when one of the facets was covered with an anti-reflection coating while the other facet was covered with a high reflection coating. The anti-reflection coating used had the refractive index of 1%, and the high reflection coating 97%. The conditions in temperature and light emission were the same as above. The output in this example was saturated at 1.3 W and no COD was caused.

As shown in FIGs. 4a - 4d, when disordering was fully completed, the band gap increased up to the value of the barrier layer. If facets of a quantum well structure are disordered, the band gap in the regions will increase to eliminate absorption completely.

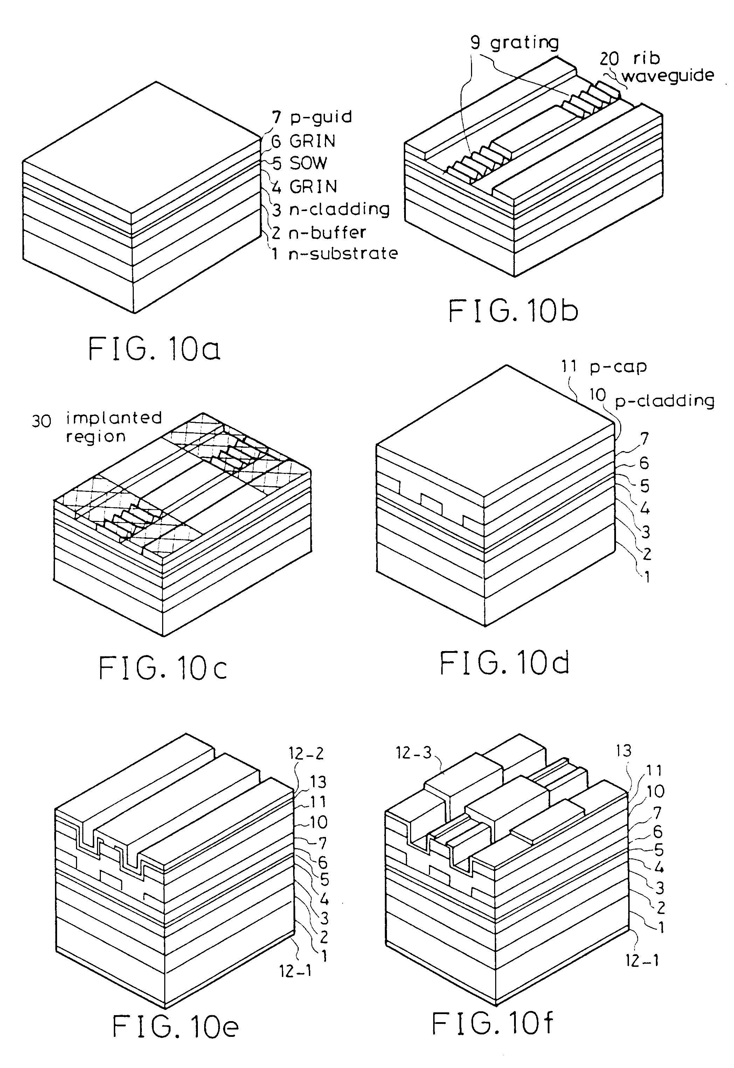

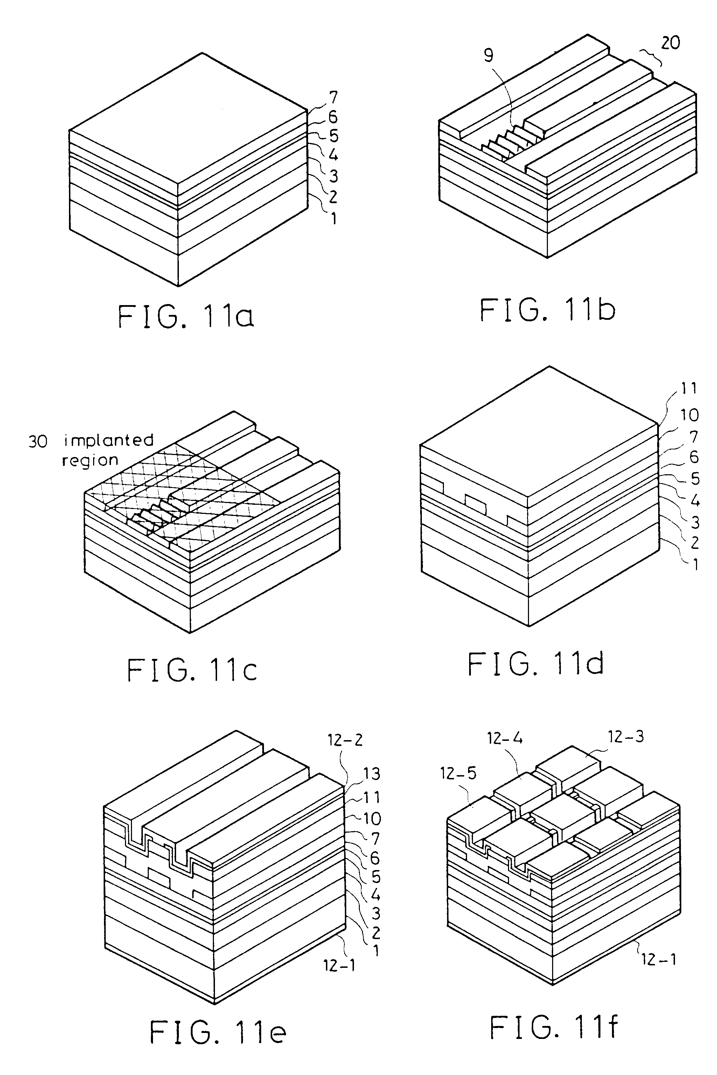

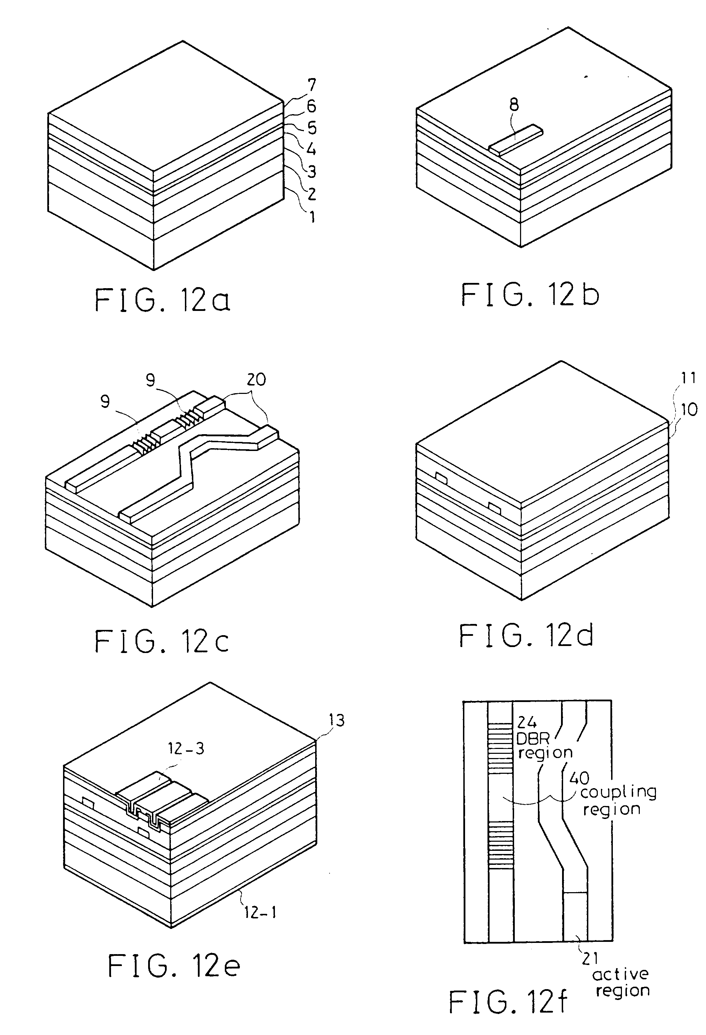

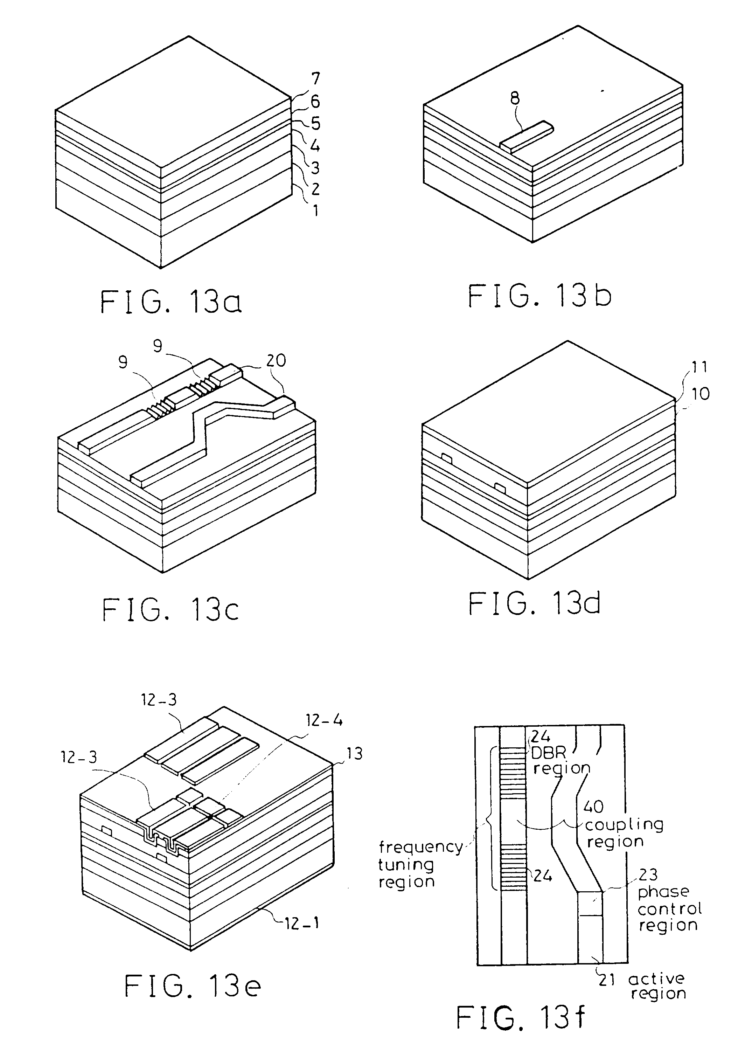

FIGs. 10 through 13 show the manufacturing process of a DBR laser, a frequency tunable DBR laser, a ROR laser, and a frequency tunable ROR laser as further embodiments according to this invention. The ROR laser and the frequency tunable ROR laser are shown in plane view in FIGs. 12f and 13f.

In the manufacturing process of a DBR laser, in a manner similar to those shown in FIGs. 1a -1h, an active region and DBR regions were formed within the rib waveguide 20. DBR regions were provided on both sides of the active region in this embodiment. A grating was provided on the DBR region and the quantum well structure thereof was disordered. The upper electrode 12-2 was removed except for the active region, and the remaining portion was used as a driving electrode 12-3.

In the process for the frequency tunable DBR laser, an active region, a phase control region and a DBR region were formed within the rib waveguide 20. The upper electrode 12-2 was split to form a driving electrode 12-3, a phase control electrode 12-4 and a frequency tuning electrode 12-5 in respective regions.

In the process for the ROR laser, the active region 21 and the DBR region were formed separately in different waveguides and a coupling region 40 was provided in a manner to couple propagated lights between the separate waveguides. The DBR regions 24 were provided on both sides of the coupling region 40.

In order to make the frequency oscillated by the ROR laser tunable, the waveguide on the side of the active region 21 is provided with a phase control region 23, the active region 21 with a driving electrode 12-3, the phase control region 23 with a phase control electrode 12-4 and the DBR region 24 and the regions therebetween with the frequency tuning electrode 12-5.

ROR such as above is described in detail in Rudolf F. Kazarinov, Charles H. Henry, and N. Anders Olsson, "Narrow-band resonant optical reflectors and resonant transformers for laser stabilization and wavelength division multiplexing", IEEE Journal of Quantum Electronics, VoL.QE-23, No. 9, September, 1987. The semiconductor laser using an ROR as an extra-cavity is described in detail in N. A. Olsson, C. H. Henry, R. F. Kazarinov, H. J. Lee, B. H. Johnson and K. J. Orlowsky, "Narrow linewidth 1.5 um semiconductor laser with a resonant optical reflector", Appl. Phys. Lett. 51(15), October 1987. As to the technology for integrating semiconductor laser with RORs on the same substrate, the present applicant has filed a patent application (JPA Sho 63-218981).

Although the above embodiments describe the cases where 28 Si was used as ions to be implanted, other ions may be used to realize this invention process.

So far as a quantum well structure is used, the semiconductor laser may have any structure for confining light or other purposes. Therefore, this invention process is applicable to the manufacturing steps for broad area semiconductor laser or for laser array.

## Claims

1. A process for manufacturing a semiconductor optical device, comprising a first epitaxial step of forming on a substrate a quantum well structure including an active layer (5) and a guiding layer on said quantum well structure, a step of etching said guiding layer (7) to form a rib waveguide (20), a step of disordering part of said quantum well structure, said etching and disordering steps not necessarily carried out in that order, the degree of the disordering being controlled to set the band gap of the corresponding part of the active layer variably, thus forming a waveguiding region which includes said rib waveguide and a disordered part of said quantum well structure, the non-disordered part of said quantum well structure being used as an active region whose output light is guided in said waveguiding region, and a second epitaxial step of embedding the rib waveguide in a cladding layer.

2. A process as claimed in claim 1, wherein the quantum well structure comprises a single quantum well.

3. A process as claimed in claim 1 or claim 2, wherein the disordering is effected by ion implantation, followed by thermal processing that is conducted by the said second epitaxy step.

4. A semiconductor optical device comprising on a substrate a quantum well structure including an active layer (5) and a rib waveguide (20) on said quantum well structure, said quantum well structure having a disordered part such that the band gap of the corresponding part of the active layer is set variably, a waveguiding region which includes said rib waveguide and a disordered part of said quantum well structure, the non-disordered part of said quantum well structure being used as an active region whose output light is guided in said waveguiding region, said rib waveguide being embedded in a cladding layer.

5. A device as claimed in claim 4, wherein the quantum well structure comprises a single quantum well.

## Patentansprüche

1. Ein Verfahren für die Herstellung einer optischen Halbleiterkomponente, umfassend einen ersten Epitaxialschritt der Bildung, auf einem Substrat, einer Quantensenkestruktur einschließlich einer aktiven Schicht (5) und einer Führungsschicht auf der Quantensenkestruktur, einen Schritt des Ätzens der Führungsschicht (7) zur Bildung eines Rippenwellenleiters (20), einen Schritt der Fehlordnung eines Teils der Quantensenkestruktur, welcher Ätz- und Fehlordnungsschritt nicht notwendigerweise in dieser Reihenfolge ausgeführt werden, wobei das Ausmaß der Fehlordnung gesteuert wird zum variablen Setzen der Bandlücke des entsprechenden Teils der aktiven Schicht, wodurch ein Wellenleiterbereich gebildet wird, der den Rippenwellenleiter und einen fehlgeordneten Teil der Quantensenkestruktur umfaßt, während der nicht fehlgeordnete Teil der Quantensenkestruktur als ein aktiver Bereich verwendet wird, dessen Ausgangslicht in dem Wellenleiterbereich geführt wird, und einen zweiten Epitaxialschritt der Einbettung des Rippenwellenleiters in eine Abdeckschicht.

2. Ein Verfahren nach Anspruch 1, bei dem die Quantensenkestruktur eine einzige Quantensenke umfaßt.

3. Ein Verfahren nach Anspruch 1 oder Anspruch 2, bei dem die Fehlordnung durch Ionenimplantation bewirkt wird, gefolgt von einer thermischen Behandlung, die durch den zweiten Epitaxialschritt ausgeführt wird.

4. Eine optische Halbleiterkomponente, umfassend, auf einem Substrat, eine Quantensenkestruktur einschließlich einer aktiven Schicht (5) und eines Rippenwellenleiters (20) auf der Quantensenkestruktur, welche Quantensenkestruktur einen fehlgeordneten Teil derart aufweist, daß die Bandlücke des entsprechenden Teils der aktiven Schicht variabel eingestellt wird, einen Wellenleiterbereich, der den Rippenwellenleiter und einen fehlgeordneten Teil der Quantensenkestruktur umfaßt, während der nicht fehlgeordnete Teil der Quantensenkestruktur als ein aktiver Bereich verwendet wird, dessen Ausgangslicht in dem Wellenleiterbereich geführt wird, wobei der Rippenwellenleiter in eine Abdeckschicht eingebettet ist.

5. Eine Komponente nach Anspruch 4, bei der die Quantensenkestruktur eine einzige Quantensenke umfaßt.

## Revendications

1. Processus de fabrication d'un dispositif optique à semi-conducteur comprenant une première étape de formation épitaxiale sur un substrat, d'une structure à puits quantique comprenant une couche active (5) et une couche de guidage sur ladite structure à puits quantique, une étape de gravure de ladite couche de guidage (7) de façon à former un guide d'onde en nervure (20), une étape de dislocation d'une partie de ladite structure à puits quantique, lesdites étapes de gravure et de dislocation n'étant pas nécessairement effectuées dans cet ordre, le taux de la dislocation étant commandé pour établir de façon variable la largeur de bande interdite de la partie correspondante de la couche active, en formant ainsi une région de guidage d'onde, laquelle comprend ledit guide d'onde en nervure et une partie disloquée de ladite structure de puits quantique, la partie non disloquée de ladite structure de puits quantique étant utilisée en tant que région active dont la lumière de sortie est guidée dans ladite région de guidage d'onde et une seconde étape épitaxiale d'incrustation du guide d'onde en nervure dans une couche de placage.

2. Processus selon la revendication 1, dans lequel la structure de puits quantique est constituée d'un puits quantique unique.

3. Processus selon la revendication 1 ou la revendication 2 dans lequel la dislocation est effectuée par implantation ionique, suivi d'un traitement thermique qui est effectué par ladite seconde étape d'épitaxie.

4. Dispositif optique à semi-conducteur comportant sur un substrat une structure de puits quantique comprenant une couche active (5) et un guide d'onde en nervure (20) sur ladite structure de puits quantique, ladite structure de puits quantique possédant une partie disloquée de telle sorte que la largeur de bande interdite de la partie correspondante de la couche active soit établie de façon variable, une région de guidage d'onde qui comprend ledit guide d'onde en nervure et une partie disloquée de ladite structure de puits quantique, la partie non disloquée de ladite structure de puits quantique étant utilisée en tant que région active dont la lumière de sortie est guidée dans ladite région de guidage d'onde, ledit guide d'onde en nervure étant réalisé dans une couche de placage.

5. Dispositif selon la revendication 4 dans lequel la structure de puits quantique est constituée d'un puits quantique unique.
